# EUROPÄISCHE PATENTSCHRIFT

(11) **EP 0 697 124 B1**
(45) Veröffentlichungstag und Bekanntmachung des Hinweises auf die Patenterteilung: **27.10.1999**
(21) Anmeldenummer: 94912473.9
(22) Anmeldetag: 20.04.1994
(51) Int. Cl.: G10L 3/00, G10L 9/14

(54) **VEKTORCODIERVERFAHREN, INSBESONDERE FÜR SPRACHSIGNALE**
VECTOR CODING PROCESS, ESPECIALLY FOR VOICE SIGNALS
PROCEDE DE CODAGE VECTORIEL, NOTAMMENT POUR SIGNAUX VOCAUX

(30) Priorität: 07.05.1993 DE 4315313
(43) Veröffentlichungstag der Anmeldung: 21.02.1996
(73) Patentinhaber: ROBERT BOSCH GMBH, 70442 Stuttgart (DE)
(72) Erfinder: MÜLLER, Jörg-Martin, D-71409 Schwaikheim (DE); WÄCHTER, Bertram, D-71573 Allmersbach/Tal (DE)
(86) Internationale Anmeldenummer: DE9400436
(87) Internationale Veröffentlichungsnummer: WO9427285

(56) Entgegenhaltungen:
- US-A- 4 868 867
- ANT NACHRICHTENTECHNISCHE BERICHTE, Bd.5, November 1988, DE Seiten 93 - 105 MÜLLER ET AL. 'RELP-Sprachkodierung mittels "Analyse durch Synthese"' in der Anmeldung erwähnt
- INTERNATIONAL CONFERENCE ON ACOUSTICS, SPEECH AND SIGNAL PROCESSING 91, Bd.1, 14. Mai 1991, TORONTO, ONTARIO, CA Seiten 241 - 244 TANIGUCHI ET AL. 'Pitch Sharpening for Perpetually Improved CELP, and the Sparse-Delta Codebook for Reduced Computation'
- INTERNATIONAL CONFERENCE ON ACOUSTICS, SPEECH AND SIGNAL PROCESSING 90, Bd.1, 3. April 1990, ALBUQUERQUE, NM, US TRANCOSO ET AL. 'CELP: A Candidate for GSM Half-Rate Coding'

## Beschreibung

Die Erfindung geht aus von einem Vektorcodierverfahren, insbesondere für Sprachsignale, unter Verwendung eines Codebuches zur Prädiktionscodierung.

Bei der Codierung und Decodierung von Sprachsignalen, insbesondere für Mobilfunkanwendungen, wird das Sprachsignal abgetastet und in Abschnitte (Zeitabschnitte) unterteilt. Für jeden Abschnitt werden Prädiktionswerte für unterschiedliche Arten von Signalparametern gebildet. Solche Signalparameter sind z.B. Kurzzeitparameter zur Charakterisierung der Formantstruktur (Resonanzen des Sprachtraktes) und Langzeitparameter zur Charakterisierung der Pitchstruktur (Tonhöhe) des Sprachsignals (ANT Nachrichtentechnische Berichte, Heft 5, Nov. 1988, Seiten 93 bis 105). Bei der Sprachcodierung mittels "Analyse durch Synthese" werden die Modell- und Anregungsparameter quantisiert, codiert und zum Empfänger übertragen. Zur weiteren Reduzierung der Bitrate wird die Vektorquantisierung benutzt (s.o.; DE/EP 0 266 620 T1; EP 504 627 A2; EP 294 020 A2).

Aus ANT Nachrichtentechnische Berichte, Heft 5, November 1988, Seiten 93 bis 105, insbesondere Seite 102, 2. Spalte bis Seite 103, 2. Spalte, ist bekannt, daß bis zu 90 % der Komponenten des Codebuchvektors auf Null gesetzt werden können, ohne die Sprachqualität zu verschlechtern. Außerdem wird dort vorgeschlagen, die Anzahl der Anregungssequenzen für das Filter zur synthetischen Spracherzeugung noch stärker einzuschränken, indem nicht nur die Position der Impulse (Koeffizienten) sondern zusätzlich ihre Amplituden fest gewählt werden. Es wird dort ein festes Anregungscodebuch gewählt, dessen Vektoren vier von Null verschiedene Elemente (Vektorkomponenten) enthalten.

Aufgabe vorliegender Erfindung ist es das Verfahren eingangs genannter Art so weiterzubilden, daß bei reduzierter Speicher- und Verarbeitungsaufwand Codebuchparameter zu Verfügung stehen, die eine geringe Fehlerempfindlichkeit, insbesondere für Übertragungszwecke über gestörte Kanäle, aufweisen.

Diese Aufgabe wird durch die Schritte des Anspruchs 1 gelöst. Die weiteren Ansprüche zeigen vorteilhafte Ausgestaltungen dieses Verfahrens aus.

Dem Verfahren nach der Erfindung liegen folgende Erkenntnisse zugrunde:
Die aus den Autokorrelationskoeffizienten gebildeten Kombinationsmuster müssen nicht abgespeichert werden. Es genügt, wenn ihre Adressen; d.h. ihre Lage, abgespeichert wird. Dies reduziert den Speicheraufwand und die Verarbeitung erheblich. Kombinationsmuster und deren Verteilung können getrennt übertragen werden. Da Sprachcodes empfindlicher reagieren auf Impulsmuster (Kombinationsmuster aus den Autokorrelationskoeffizienten) als auf deren Verteilung (Anordnung der Vektorkomponenten), ergibt sich eine bessere Sprachqualität bei gestörter Übertragung. Aus diesem Grunde ist das Verfahren nach der Erfindung, insbesondere für den Mobilfunk vorteilhaft einsetzbar.

Anhand der Zeichnungen wird ein Ausführungsbeispiel der Erfindung näher erläutert. Es zeigen
Figur 1 das Prinzip der RELP-Sprachcodierung,
Figur 2 das Prinzip der Analyse durch Synthese,
Figur 3 ein Beispiel für die Wahl der Autokorrelationskoeffizienten nach der Erfindung und
Figur 4 Teilcodebücher mit der Verteilung der Impulsmuster.

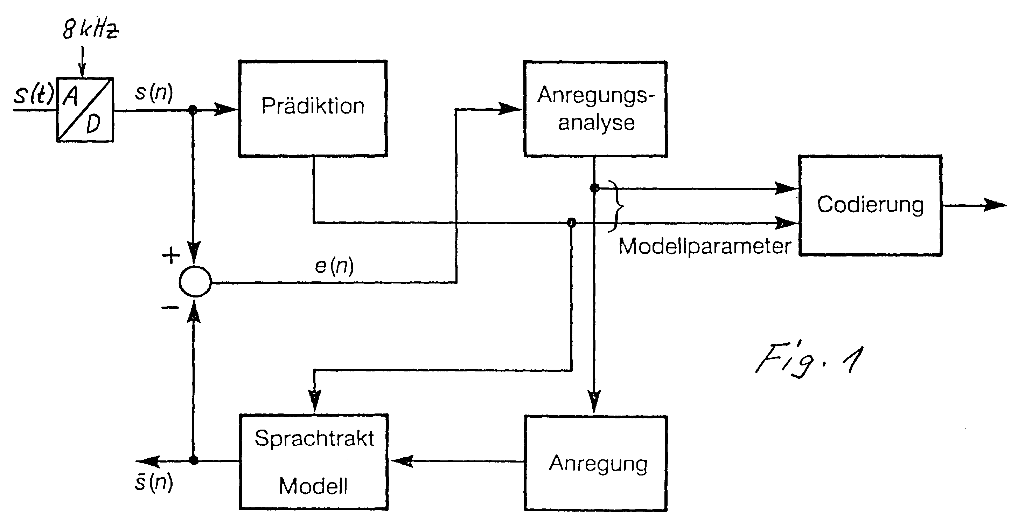

Zur Übertragung von Sprachsignalen mit niedrigen Bitraten, z.B. im Bereich von 2,4 kbit/s bis 9,6 kbit/s, wird beispielsweise ein RELP-Sprachcodec nach dem Prinzip "Analyse durch Synthese" verwendet. Die Sprachcodierung z.B. nach dem RELP-Prinzip (ANT Nachrichtentechnische Berichte, Heft 5, 1988, Seiten 93 bis 105) ist zum weiteren Verständnis der Erfindung in Figur 1 kurz erläutert. Ein Sprachsignal s(t) wird mittels eines A/D-Wandlers digitalisiert und anschließend analysiert.

Diese Analyse umfaßt die Funktionsblöcke Prädiktion und Anregungsanalyse. Zur Beseitigung der Sprachredundanz wird eine Nachbildung der Spracherzeugung durch ein lineares adaptives Modell, das geeignet angeregt wird, verwendet. Es werden lediglich die für die Sprachsynthese erforderlichen Modell- und Anregungsparameter quantisiert, codiert und zum Empfänger übertragen. Zur Bestimmung der Modellparameter werden im Sender statistische Abhängigkeiten der Sprachabtastwerte analysiert und mittels linearer Kurzzeit- und gegebenenfalls auch Langzeitprädiktion weitgehend eliminiert. Durch die Kurzzeitprädiktion werden Korrelationen zwischen unmittelbar aufeinanderfolgenden Abstastwerten weitgehend beseitigt. Korrelationen zwischen weit auseinanderliegenden Abtastwerten (Pitchstruktur) werden durch einen nachfolgenden Langzeitprädiktor reduziert. Das Ergebnis ist ein Signal, das im wesentlichen nur noch nichtlineare Abhängigkeiten aufweist und dessen Energie im Vergleich zur Energie des ursprünglichen Sprachsignals stark reduziert ist. Bei der "Analyse durch Synthese" wird zur Berechnung des Anregungssignals die Differenz zwischen Original- und synthetisiertem Sprachsignal verwendet (Figur 1).

Innerhalb kurzer Sprachabschnitte von ca. 10 bis 30 ms Dauer kann die Sprache als quasistationärer Prozeß betrachtet werden. Diese Quasistationarität ermöglicht die Berechnung von Prädiktoren, deren Parameter für die Dauer des Sprachabschnitts konstante Werte annehmen. Ein Sprachabschnitt von 20 ms Dauer wird beispielsweise als Rahmendauer festgelegt. Dann stehen bei einer Abtastfreqeunz von 8 kHz zur Adaption der Prädiktorkoeffizienten jeweils 160 Abtastwerte pro Rahmen zur Verfügung. Die Prädiktionsfehler werden durch Minimierung der Energie des Prädiktionsfehlers pro Rahmen ermittelt. Zur Bestimmung dieser Prädiktionskoeffizienten wird zur Vereinfachung des Rechenaufwandes die Korrelationsmethode angewendet.

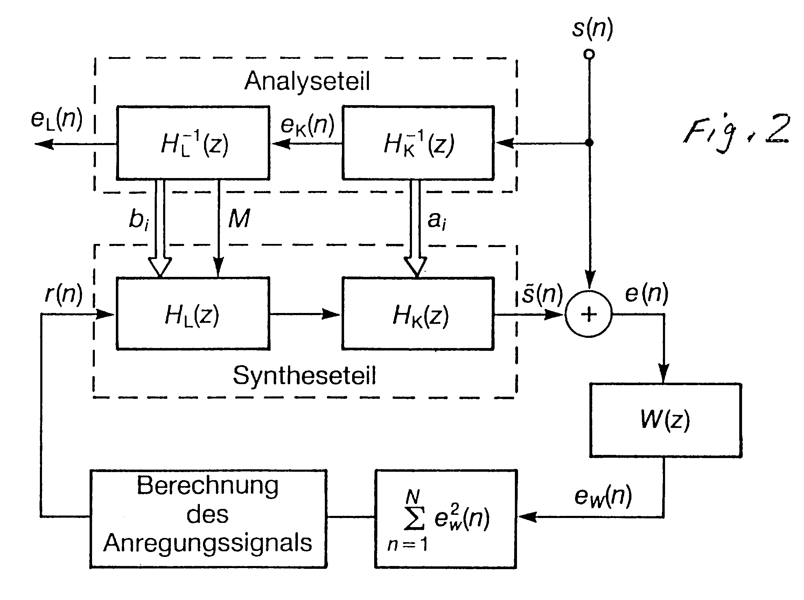

Nach der Analyse des Sprachsignals s(n) sind die Koeffizienten der Sprachsynthesefilter, welche in Figur 2 durch die Übertragungsfunktion H_{L}(Z) H_{K}(Z) charakterisiert sind, bekannt. Die Anregung r(n) für die Synthesefilter wird entweder berechnet oder gemäß der Erfindung aus einem Codebuch ausgelesen. Das Ausgangssignal s(n) der Synthesefilter ist das geschätzte Sprachsignal. Durch Vergleich mit dem Originalsignal s(n) ergibt sich das Fehlersignal e(n), das mit der Übertragungsfunktion W_{(Z)} hörphysiologisch gewichtet wird. Die Energie des Fehlersignals wird dann zur Ermittlung eines verbesserten Anregungssignals verwendet.

Zur weiteren Reduzierung der Bitrate für die Übertragung wird die Vektorquantisierung verwendet. Die Berechnung des Anregungssignals wird durch ein Codebuch mit L Anregungsvektoren der Dimension D ersetzt. Mit Hilfe eines Skalierungsfaktors wird die Energie jedes Vektors an die Energie des Sprachsignals angepaßt. Die Adresse desjenigen Vektors mit der kleinsten Fehlerenergie wird dann zum Empfänger übertragen. Da das Prädiktionsfehlersignal in sehr guter Näherung gaußverteilt ist, kann das Codebuch mit gaußverteilten Zufallszahlen besetzt werden. Der Vorteil dieser sogenannten CELP-Verfahren (Codebook Excited Linear Prediction) liegt unter anderem darin, daß das Codebuch nicht "trainiert" zu werden braucht. Eine weitere Aufwandsverminderung ergibt sich, wenn Codebuchvektoren verwendet werden, die Nullvektoren enthalten. Zur Berechnung des Anregungsvektors werden damit weniger Rechenoperationen benötigt. In ANT Nachrichtentechnische Berichte, Heft 5, Nov. 1988, Seiten 93 bis 105 wurde vorgeschlagen, möglichst viele Komponenten der Codebuchvektoren, z.B. bis zu 90 %, auf Null zu setzen (Seite 103, linke Spalte, letzter Absatz) und die Anzahl der Anregungssequenzen noch stärker einzuschränken durch Festlegung der Positionen der Koeffizienten (Impulse) und Konstanthaltung ihrer Amplituden. Es wurden dort Vektoren für das Codebuch verwendet, die vier von Null verschiedene Elemente enthalten.

Bei der Erfindung werden diese Forderungen zugunsten des Speicherbedarfs und Verarbeitungsaufwandes noch weiter eingeschränkt: Es werden nur Vektoren verwendet, die drei von Null verschiedene Autokorrelationskoeffizienten aufweisen. Die außerhalb vom Korrelationsmaximum AKF₍₀₎ gelegenen Autokorrelationskoeffizienten werden so gewählt, daß sie sich nur in ihrem Vorzeichen unterscheiden; d.h. ihre Amplitude ist gleich.

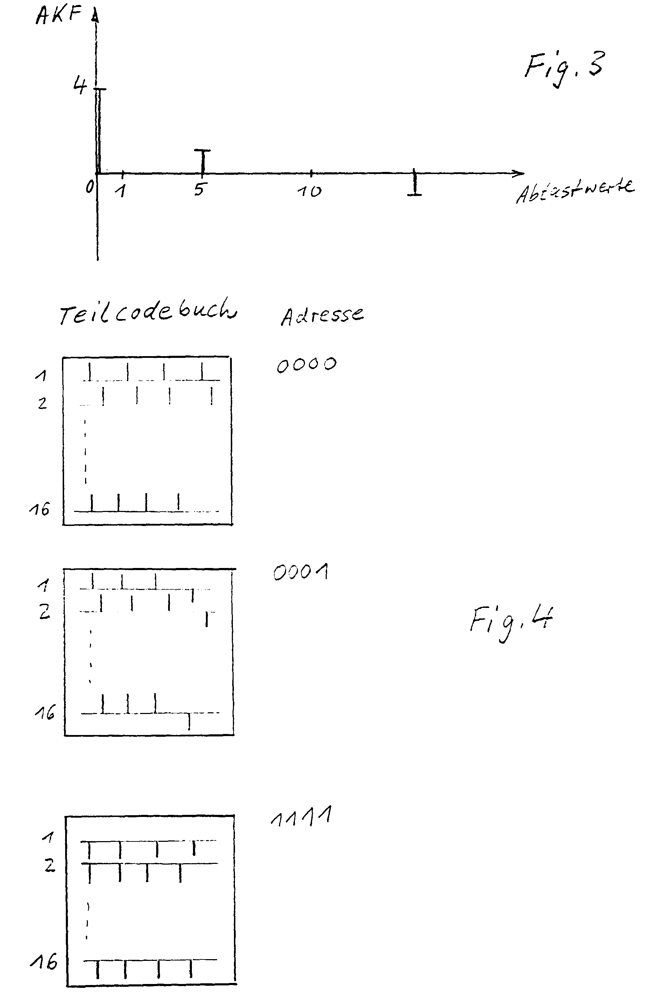

In Figur 3 ist ein Beispiel für solchermaßen gewählte Autokorrelationskoeffizienten aufgezeigt mit n=4 Impulsen, d.h. Amplitudenbits innerhalb eines Rahmens von beispielsweise 40 Abtastwerten. Beim Korrelationsmaximum AKF₍₀₎ ergibt sich der Amplitudenwert 4. Da dieser Wert für alle Impulsmuster mit n-Impulsen konstant ist, muß er nicht abgespeichert werden. Die übrigen von Null verschiedenen Impulse haben die Amplitude 1. Beispielsweise ist der 5. Abtastwert +1 und der 15. Abtastwert -1.

Die hier verwendeten Autokorrelationskoeffizienten sind so definiert, daß sich bei Verknüpfung mit der Autokorrelationsfunktion der Impulsantwort eines Anregungsfilters zur Erzeugung synthetischer Signale (Sprachsignale), die Energie des gefilterten Anregungssignals ergibt.

Außerdem wird für alle Kombinationsmuster, die aus derartigen Autokorrelationskoeffizienten gebildet werden können, gefordert, daß sie im Codebuch gleichhäufig auftreten. Durch letztere Forderung kann das Codebuch mit einem Umfang 2^{L} in n Teilcodebücher zerlegt werden, wenn im Anregungssignal n von Null verschiedene Pulse zugelassen sind, was 2ⁿ möglichen Kombinationsmustern entspricht. Jedes der n Teilcodebücher hat den Umfang 2^{L-n} und enthält nur gleichartige Impulsmuster. In Figur 4 sind einige von den 2ⁿ (n=4) = 16 möglichen Teilcodebüchern dargestellt. Die Impulsmuster in jedem der Teilcodebücher sind jeweils gleich (Reihenfolge der +1 und -1 Werte) nur die Lage der einzelnen Impulse unterscheidet sich. Im ersten Teilcodebuch besteht das Impulsmuster nur aus vier positiven Impulsen, im zweiten Teilcodebuch aus 3 positiven und einem negativen Impuls, usw. Die Codebuchlänge L umfaßt demnach 256 Vektoren. Durch die Gleichhäufigkeit der Kombinationsmuster (Impulsmuster) können die Kombinationsmuster getrennt von der Verteilung (Lage) der Impulse übertragen werden. Die Kombinationsmuster müssen nicht selbst abgespeichert und übertragen werden. Es genügt, wenn jedes der 16 Teilcodebücher mit bekanntem Kombinationsmuster vom anderen unterscheidbar ist. Am einfachsten läßt sich dies dadurch realisieren, wenn jedem Teilcodebuch und damit dem jeweiligen Impulsmuster eine andere Adresse zugeordnet wird, z.B. dem ersten Teilcodebuch die Adresse 0000 und dem zweiten Teilcodebuch die Adresse 0001 usw. (Fig. 4). Für die Lage der Impulse in den Teilcodebüchern muß ebenfalls jeweils nur eine Adresse gespeichert und übertragen werden.

Anstelle der Erstellung von 16 Teilcodebüchern genügt es nur 8 Teilcodebücher mit unterschiedlichen Kombinationsmustern zu erzeugen (Teilcodebücher 1 bis 8). Die Teilcodebücher 9 bis 16 können dann durch einfache Vorzeicheninversion der Kombinationsmuster erstellt werden. Zum Beispiel wird aus dem Muster 11-1-1 das Muster -1-111.

Durch die Separation der Impulsmuster von der Impulsverteilung ergibt sich eine sehr hohe Fehlerrobustheit der Sprachübertragung insbesondere bei Übertragungsstörungen, da Codecs empfindlicher auf Impulsmuster reagieren als auf deren Verteilung. Die Impulsmuster können daher beispielsweise bei einer Kanalcodierung für die Übertragung mit einem höheren Fehlerschutz versehen werden als die Information über die spezielle Lage ihrer Impulse.

## Patentansprüche

1. Vektorcodierverfahren, insbesondere für Sprachsignale, unter Verwendung von Codebüchern, wobei in einem ersten Codebuch Kombinationsmuster für Anregungssignale (Vektoren) eines Anregungsfilters zur Erzeugung synthetischer Signale, insbesondere von Sprachsignalen, mit n, insbesondere 4, von Null verschiedenen betragsmäßig gleichen und sich nur im Vorzeichen unterscheidenden Amplitudenwerte bzw. die Adressen zur Abspeicherung dieser Kombinationsmuster gespeichert sind und in einem weiteren Codebuch die jeweils dazugehörigen Autokorrelationskoeffizienten gespeichert sind, mit folgenden Schritten:
- im weiteren Codebuch werden Autokorrelationskoeffizienten abgespeichert, die bei Verknüpfung mit der Autokorrelationsfunktion der Impulsantwort des Anregungsfilters zur Erzeugung synthetischer Signale, insbesondere von Sprachsignalen, die Energie des gefilterten Anregungssignals ergeben,
- es werden nur solche Kombinationsmuster zugelassen, die drei vom Wert Null verschiedene Autokorrelationskoeffizienten aufweisen,
- die von Null verschiedenen Amplitudenwerte der außerhalb vom Korrelationsmaximum AKF (0) gelegenen Autokorrelationskoeffizienten unterscheiden sich nur in ihrem Vorzeichen.

2. Vektorcodierverfahren nach Anspruch 1, dadurch gekennzeichnet, daß nur jene von Null verschiedenen Autokorrelationskoeffizienten im ersten Codebuch abgespeichert werden, die außerhalb des Korrelationsmaximums (AKF(0)) gelegen sind.

3. Vektorcodierverfahren nach Anspruch 1 oder 2, dadurch gekennzeichnet, daß für jedes mögliche Kombinationsmuster ein Teilcodebuch gebildet wird und daß in ein Teilcodebuch nur die jeweilige Lage des für jedes der Teilcodebücher gleichen Kombinationsmusters eingetragen wird.

4. Vektorcodierverfahren nach Anspruch 3, dadurch gekennzeichnet, daß die Teilcodebücher zur gegenseitigen Unterscheidung durch ein Codewort gekennzeichnet werden.

5. Vektorcodierverfahren nach einem der Ansprüche 3 oder 4, dadurch gekennzeichnet, daß die Kombinationsmuster aus vier Koeffizienten mit den Amplitudenwerten +1 und -1 gebildet werden.

6. Vektorcodierverfahren nach einem der Ansprüche 3 bis 5, dadurch gekennzeichnet, daß bei einer Codebuchlänge von 256 Vektoren insgesamt 16 Teilcodebücher erstellt werden, in die jeweils die Kombinationsmuster für 16 Vektoren zeilenweise eingetragen werden.

7. Vektorcodierverfahren nach Anspruch 6, dadurch gekennzeichnet, daß anstelle von 16 Teilcodebüchern nur 8 Teilcodebücher erstellt werden und die übrigen 8 Teilcodebücher aus den 8 zuvor erstellten Teilcodebüchern durch Vorzeicheninversion der Einträge erzeugt werden.

## Claims

1. Vector-encoding method, in particular for voice signals, using codebooks, there being stored in a first codebook combination patterns for excitation signals (vectors) of an excitation filter for generating synthetic signals, in particular voice signals, with n, in particular 4, amplitude values other than zero, of the same amount and differing only in operational sign, or the addresses for storing these combination patterns, and there being stored in a further codebook the respectively associated autocorrelation coefficients, having the following steps:
- stored in the further codebook are autocorrelation coefficients which, when they undergo a logic operation with the autocorrelation function of the pulse response of the excitation filter for generating synthetic signals, in particular voice signals, give the energy of the filtered excitation signal,
- allowed are only those combination patterns which have three autocorrelation coefficients other than the value zero,
- the amplitude values other than zero of the autocorrelation coefficients outside the correlation maximum (AKF₍₀₎) differ only in their operational sign.

2. Vector-encoding method according to Claim 1, characterized in that only those autocorrelation coefficients other than zero which are outside the correlation maximum (AKF₍₀₎) are stored in the first codebook.

3. Vector-encoding method according to Claim 1 or 2, characterized in that a part-codebook is formed for each possible combination pattern and characterized in that only the respective position of the combination pattern, which is the same for each of the part-codebooks, is entered into a part-codebook.

4. Vector-encoding method according to Claim 3, characterized in that the part-codebooks are identified by a code word for distinguishing them from one another.

5. Vector-encoding method according to one of Claims 3 or 4, characterized in that the combination patterns are formed from four coefficients with the amplitude values +1 and -1.

6. Vector-encoding method according to one of Claims 3 to 5, characterized in that in the case of a codebook length of 256 vectors, a total of 16 part-codebooks are created, into which in each case the combination patterns for 16 vectors are entered line by line.

7. Vector-encoding method according to Claim 6, characterized in that, instead of 16 part-codebooks, only 8 part-codebooks are created and the other 8 part-codebooks are produced from the 8 previously created part-codebooks by inverting the operational sign of the entries.

## Revendications

1. Procédé de codage vectoriel, notamment pour des signaux vocaux utilisant des livres de codes, selon lequel
• dans un premier livre de codes on enregistre les modèles de combinaison des signaux d'excitation (vecteurs) d'un filtre d'excitation pour générer des signaux de synthèse, notamment des signaux vocaux, avec (n) différent de zéro, notamment égal à 4, valeurs d'amplitude de mesure égale mais de signe algébrique différent où les adresses sont mémorisées pour ces modèles de combinaison, et
• un autre livre de codes contient les coefficients d'autocorrélation correspondants,
procédé comprenant les étapes suivantes :
- dans un autre livre de codes on mémorise des coefficients d'autocorrélation qui, en combinaison avec la fonction d'autocorrélation de la réponse impulsionnelle du filtre d'excitation, génèrent des signaux de synthèse, notamment des signaux vocaux, donnant l'énergie du signal d'excitation filtré,
- seuls sont autorisés des modèles de combinaison ayant trois coefficients d'autocorrélation différents de zéro,
- les valeurs d'amplitude différentes de zéro, situées à l'extérieur du maximum de corrélation AKF (O) des coefficients d'autocorrélation, ne se distinguent que par leur signe algébrique.

2. Procédé de codage vectoriel selon la revendication 1,
caractérisé en ce qu'
on mémorise dans le premier livre de codes les seuls coefficients d'autocorrélation différents de zéro, situés à l'extérieur du maximum de corrélation (AKF(O)).

3. Procédé de codage vectoriel selon la revendication 1 ou la revendication 2,
caractérisé en ce qu'
on forme un livre de codes partiels pour chaque modèle de combinaison possible et
dans un livre de codes partiels on enregistre uniquement la position respective du modèle de combinaison égal pour chacun des livres de codes partiels.

4. Procédé de codage vectoriel selon la revendication 3,
caractérisé en ce qu'
on caractérise les livres de codes partiels par un mot de code pour les distinguer les uns par rapport aux autres.

5. Procédé selon l'une des revendications 3 ou 4,
caractérisé en ce qu'
on forme le modèle de combinaison à partir de quatre coefficients avec des valeurs d'amplitude (+1) et (-1).

6. Procédé selon l'une des revendications 3 à 5,
caractérisé en ce que
pour une longueur de livre de codes de 256 vecteurs, on établit en tout 16 livres de codes partiels dans lesquels on enregistre chaque fois, ligne par ligne, les modèles de combinaison des 16 vecteurs.

7. Procédé selon la revendication 6,
caractérisé en ce qu'
à la place des 16 livres de codes partiels on établit seulement 8 livres de codes partiels et on génère les autres 8 livres de codes partiels à partir des 8 livres de codes partiels établis précédemment en enregistrant une inversion de signe algébrique.
